(19)

Europäisches
Patentamt

European
Patent Office

Office européen
des brevets

(11)　EP 4 675 875 A1

(12)　EUROPEAN PATENT APPLICATION

(43) Date of publication:
     **07.01.2026　Bulletin 2026/02**

(21) Application number: **24186623.5**

(22) Date of filing: **04.07.2024**

(51) International Patent Classification (IPC):
     *H02H 3/16* (2006.01)　　　*H02H 7/18* (2006.01)
     *G01R 31/52* (2020.01)

(52) Cooperative Patent Classification (CPC):
     **H02H 3/16; G01R 31/52; H02H 7/18;** H02J 7/0029

(84) Designated Contracting States:
     **AL AT BE BG CH CY CZ DE DK EE ES FI FR GB
     GR HR HU IE IS IT LI LT LU LV MC ME MK MT NL
     NO PL PT RO RS SE SI SK SM TR**
     Designated Extension States:
     **BA**
     Designated Validation States:
     **GE KH MA MD TN**

(71) Applicant: **ABB Schweiz AG
     5400 Baden (CH)**

(72) Inventors:
     • **FLANKL, Michael
       8032 Zurich (CH)**
     • **LONG, Shannon
       8803 Rüschlikon (CH)**

(74) Representative: **Sykora & König Patentanwälte
     PartG mbB
     Maximilianstraße 2
     80539 München (DE)**

(54)　**METHOD, CONTROLLER, AND IMD FOR CHECKING AN EARTH-FAULT- FREE CONDITION OF AN ENERGY STORAGE SYSTEM, AND ENERGY 5 STORAGE SYSTEM**

(57)　A method for checking an earth-fault-free condition of an energy storage system (20) is described. The energy storage system (20) comprises a first battery pack (22) having a first pole (30), a second pole (32), and at least two battery cells (28) electrically arranged in series between the first pole (30) and the second pole (32). The method comprises: receiving a first voltage signal (100) being representative of a first voltage between the second pole (32) and the ground potential (34); determining a first condition as being fulfilled when the first voltage signal (100) raises above a first voltage threshold (UT1) and determining the first condition as not being fulfilled when the first voltage signal (100) does not raise above the first voltage threshold (UT1); sending a first control signal to a first switch (48), wherein the first switch (48) is configured to connect the second pole (32) to the ground potential (34) via a second resistor (46) having a predetermined second resistance upon receiving the first control signal; determining a second condition as being fulfilled when the first voltage signal (100) falls below a predetermined second voltage threshold (UT2) after the first switch (48) connected the second pole (32) to the ground potential (34) and determining the second condition as not being fulfilled when the first voltage signal (100) does not fall below the predetermined second voltage threshold (UT2) after the first switch (48) connected the second pole (32) to the ground potential (34); determining the first battery pack (22) as being in the earth-fault-free condition when the first condition and the second condition are fulfilled; determining the first battery pack (22) as not being in the earth-fault-free condition when the first condition and/or the second condition are not fulfilled; and initiating at least one safety measure when the first battery pack (22) is not in the earth-fault-free condition.

Fig. 1

**Description**

FIELD OF THE INVENTION

The invention relates to the field of energy storage systems, insulation monitoring devices, and the monitoring and/or checking of the energy storage systems. In particular, the invention relates to a method, a controller, and an Insulation Monitoring Device (IMD) for checking an earth-fault-free condition of an energy storage system, and to the energy storage system.

BACKGROUND OF THE INVENTION

Energy storage systems (ESSs) comprising battery packs are increasingly used in very complex products, such as high-voltage DC-links for propulsion applications, for example. The battery packs each may comprise two or more battery cells being arranged electrically in series, for example. The propulsion applications may be used in electric vehicles, e.g., in on-road and/or in off-road vehicles, such as e.g. mining trucks, trains, trams, and subways. For such complex applications it is generally recommendable to check insulation properties of the energy storage systems, in particular of the battery packs, regularly. There already exist Insulation Monitoring Devices (IMDs) for monitoring and/or checking insulation properties of the ESSs in the market.

However, it is a specific challenge from an electrical engineering point of view to connect multiple battery packs electrically in series in order to provide the required propulsion power, while not violating the design specifications of the battery packs. Furthermore, the harsh nature of such applications, e.g., of the mining trucks, asks for a robust, but sensitive function to detect system failures and prevent harm from people and material.

Therefore, there is a need for an ESS having an IMD to omit, reduce or make easier to detect following risks in a mining or railway application, for example:

- The ESS disturbs other components, vehicle systems, and/or infrastructure systems with regard to Electromagnetic Compatibility (EMC) due to an antenna effect.

- Internal short-circuit in ESS or battery pack during non-operation (e.g. transport, storage).

- Humidity/condensation during operation.

- Major cooling liquid leak in battery pack during operation.

- Insulation faults (single pole).

- Second earth fault internal (in addition to a first earth fault already present).

- Earth fault internal causing creepage currents.

DESCRIPTION OF THE INVENTION

It is an objective of the present invention to provide a method and a controller for checking an earth-fault-free condition of an energy storage system, which contribute to omit, reduce, and/or make easier to detect the risks mentioned above, and/or which are scalable, robust, controllable, and/or evaluable by a controller. It is another objective of the present invention to provide the energy storage system comprising the controller, and an electric vehicle comprising the energy storage system.

This objective is achieved by the subject-matter of the independent claims. Further exemplary embodiments are evident from the dependent claims and the following description.

A first aspect relates to a method for checking an earth-fault-free condition of an energy storage system. The energy storage system comprises a first battery pack having a first pole, a second pole, and at least two battery cells electrically arranged in series between the first pole and the second pole. The method comprises: receiving a first voltage signal being representative of a first voltage between the second pole and a ground potential; determining a first condition as being fulfilled when the first voltage signal raises above a first voltage threshold and determining the first condition as not being fulfilled when the first voltage signal does not raise above the first voltage threshold; sending a first control signal to a first switch, wherein the first switch is configured to connect the second pole to the ground potential via a second resistor having a predetermined second resistance upon receiving the first control signal; determining a second condition as being fulfilled when the first voltage signal falls below a predetermined second voltage threshold after the first switch connected the second pole to the ground potential and determining the second condition as not being fulfilled when the first voltage signal does not fall below the predetermined second voltage threshold after the first switch connected the second pole to the ground potential; determining the first battery pack as being in the earth-fault-free condition when the first condition and the second condition are fulfilled; determining the first battery pack as not being in the earth-fault-free condition when the first condition and/or the second condition are not fulfilled; and initiating at least one safety measure when the first battery pack is not in the earth-fault-free condition. Optionally, the first pole may be electrically coupled to the ground potential via a first resistor having a predetermined first resistance.

A second aspect relates to a controller for checking the earth-fault-free condition of the energy storage system. The controller comprises a memory for storing one or more voltage values and/or one or more voltage thresholds, and a processor being communicatively coupled with the memory and being configured to carry out the method as described above and in the following.

A third aspect relates to an Insulation Monitoring Device (IMD) for checking the earth-fault-free condition of the energy storage system. The IMD comprises: a first resistor having a predetermined first resistance; a first voltmeter for being electrically coupled to the second pole and the ground potential, and being configured to measure a first voltage between the second pole and the ground potential; a second resistor having a predetermined second resistance and being configured for providing an electric coupling of the second pole to the ground potential; a first switch electrically coupled to the second resistor and being configured for establishing or interrupting the electric coupling of the second pole to the ground potential depending on a state of the first switch; and a controller as described above and in the following and being communicatively coupled to the first voltmeter and the first switch. Optionally, the first resistor may be implemented within a further voltmeter arranged in the first battery pack, for example. Optionally, the first pole may be electrically coupled to the ground potential via a first resistor having a predetermined first resistance and/or may be configured to electrically couple the first pole to the ground potential.

A fourth aspect relates to the energy storage system for providing electric energy to a load. The energy storage system comprises: the first battery pack having the first pole, the second pole, and at least two battery cells electrically arranged in series between the first pole and the second pole; and the IMD as described above and in the following, wherein the first pole is electrically coupled to the ground potential via the first resistor of the insulation monitoring device, the first voltmeter of the insulation monitoring device is electrically coupled to the second pole and the ground potential, and is configured to measure the first voltage between the second pole and the ground potential, and the first switch electrically coupled to the second resistor and is configured for establishing or interrupting the electric coupling of the second pole to the ground potential depending on the state of the first switch.

It has to be understood that some features of the present invention are described with respect to one of the aspects only for conciseness reasons and to avoid unnecessary repetitions, but that these features may be easily transferred to one or more of the other aspects by the person skilled in the art.

The above aspects contribute to omit, reduce, and/or make easier to detect the risks mentioned above with respect to the background of the invention. In addition, the method, controller, and energy storage system are scalable, robust, controllable, and/or evaluable by a controller. The disclosed solution is much faster than state-of-the-art systems in terms of detection time and maintenance free. The controller carrying out the method represents a novel passive insulation monitoring device for battery applications. Its key contributions are a fast detection time, no current source is required for test signal injection and adjustable measurement evaluation on a standard control unit. Furthermore, two different operating modes may be established, one active operation mode at system startup in a self-check procedure and a passive operating mode during normal system operation, where any influence on other, galvanically connected elements is minimized, as explained further below. The insulation monitoring functionality is implemented with two sets of resistors, the first switch, a voltage measurement and an evaluation algorithm represented by the described method. The voltage needed for checking the battery packs is received from the battery pack, which is monitored, and is utilized for the described test sequence. So, no separate energy source is needed for checking the battery packs.

The test sequence comprises a first phase ("Phase I") in which it is checked whether the first condition is fulfilled and a second phase ("Phase II") in which it is checked whether the second condition is fulfilled. Optionally, the test sequence has a third phase ("Phase III"), as explained below. The advantage of the inventive method is that by very simple design enhancements a mitigation feature to prevent harm is incorporated, by detecting single earth faults in battery systems. Due to the described procedure, it is easy to locate the exact fault location and disconnect the faulty part. Furthermore, the conditions of the battery packs can be monitored in terms of a quantitative insulation resistance tracking, in particular in Phase I & II. These means of integration of a safety feature is cost effective, easy, may even be retrofitted to existing battery systems, and may not need any maintenance or inspection.

The first voltage may be measured by the first voltmeter. The first voltmeter may generate the first voltage signal depending on the measurement of the first voltage such that the first voltage signal is representative of the first voltage. The first voltage may be measured and the first voltage signal may be correspondingly generated continuously when carrying out the method. The first and second voltage thresholds may be predetermined in advance, e.g., depending on the first and, respectively, second resistances. The one or more voltage values may be encoded in the first voltage signal and/or in any further voltage signals. Optionally, the first resistor may be integrated within the further voltmeter.

The energy storage system may be configured for providing electric energy to a load. The load may be an electric motor, e.g., a motor for driving an electric vehicle. The electric vehicle may be configured for transporting one or more persons and/or goods. The electric vehicle may be an on-road or an off-road vehicle, e.g., a mining truck, a train, a tram, or a subway. In this context, the battery packs of the energy storage system may be referred to as propulsion battery packs of the electric vehicle.

The IMD mentioned above may be referred to as first IMD. The first IMD may comprise a housing in which its components are arranged. The controller may be configured for receiving the first voltage signal, for checking the first and/or second condition, for sending the control signal(s) to the switch(es), and in case for initiating the safety measure.

In case of the battery pack being in the earth-fault-free condition, the energy storage system, in particular the battery pack, may be operated normally. For example, in case of the energy storage system providing the propulsion energy to the electric vehicle, the energy storage system and in particular the battery pack may be used for providing the propulsion energy for the electric vehicle.

The safety measure may comprise or may be one or more safety measures out of a group of safety measures, the group comprising: deactivating the energy storage system, deactivating the battery pack, and sending a warning signal to an operator of the energy storage system, e.g., of the vehicle.

According to an embodiment, the energy storage system comprises a second switch being electrically arranged in series with the battery cells between the first pole and the second pole and wherein the second switch is configured for interrupting or establishing the serial connection of the battery cells between the first pole and the second pole, and the method comprises before receiving the first voltage signal: sending a second control signal to the second switch of the first battery pack, wherein the second switch is configured to establish the serial connection of the battery cells between the two poles of the first battery pack upon receiving the second control signal, wherein it is determined whether the first condition is fulfilled a predetermined duration after the second switch established the serial connection of the battery cells between the two poles of the first battery pack. The predetermined duration may be in the range of 0.01 s to 1.000 s, e.g., of 0.5 s to 60 s, e.g., of 1 s to 30 s. The second switch of the first battery pack may be electrically arranged between the first pole and the battery cells, between the battery cells and the second pole, or between two of the battery cells of the first battery pack. When the second switch of the first battery pack is open, the serial connection of the battery cells between the poles of the first battery pack is interrupted. Optionally, there may be two or more second switches of the first battery pack, e.g., one between the first pole and the battery cells and one between the battery cells and the second pole of the first battery pack.

According to an embodiment, the energy storage system comprises a second battery pack electrically arranged in parallel with the first battery pack, wherein the second battery pack is configured in correspondence to the first battery pack, and wherein a second switch of the second battery pack interrupts a serial connection of battery cells of the second battery pack between two poles of the second battery pack while the earth-fault-free condition of the first battery pack is checked, and the method comprises: sending a third control signal to the second switch of the first battery pack after checking the earth-fault-free condition of the first battery pack, wherein the second switch of the first battery pack is configured to interrupt the serial connection of the battery cells between the two poles of the first battery pack upon receiving the third control signal; sending the second control signal to the second switch of the second battery pack, wherein the second switch of the second battery pack is configured to establish the serial connection of the battery cells between the two poles of the second battery pack upon receiving the second control signal; and checking the earth-fault-free condition of the second battery pack.

When the battery system comprises more than two battery packs, these battery packs may be checked one after the other after checking the first and second battery packs. So, all battery packs of the battery system may be checked with respect to the earth-fault-free condition one after the other. The serial connections of the battery cells between the two poles of all the battery packs which are not currently checked may be interrupted by the corresponding second switches upon receiving the corresponding third control signals. The earth-fault-free condition of the second or in case any further battery packs may be checked in the same way as the earth-fault-free condition of the first battery pack is checked, in particular via monitoring the first voltage signal before and after closing the corresponding first switch.

That the second battery pack is configured in correspondence to the first battery pack may mean that the second battery pack has the same structure and comparable components as the first battery pack. In particular, the second battery pack and each further battery pack mentioned in this description may comprise its own first pole, second pole, and two or more battery cells being electrically arranged in series between the first pole and the second pole.

According to an embodiment, the energy storage system comprises a converter configured for electrically coupling at least the first battery pack to the load and a first contactor configured for electrically coupling the first battery pack to the converter, and the method comprises, before receiving the first voltage signal: sending a fourth control signal to the first contactor, wherein the first contactor is configured for interrupting the electrical connection between the first battery pack and the converter upon receiving the fourth control signal; and determining whether the first condition is fulfilled after the first contactor interrupted the electrical connection of the first battery pack to the first converter, and in case after the second switch established the serial connection of the battery cells between the two poles of the first battery pack. When the first contactor interrupted the electrical connection between the first battery pack and the converter, the energy storage system, in particular the first battery pack, cannot be operated normally anymore, but may be checked for the earth-fault-free condition. After checking the first battery pack with respect to its earth-fault-free condition, the electrical connection between the first battery pack and the converter may be established again by the first contactor and the energy storage system, in particular the first battery pack, can be operated normally again, if the first battery pack is determined as being in its earth-fault-free condition.

According to an embodiment, the energy storage system comprises at least the paralleled first and second battery packs, the converter is configured to electrically couple the first and second battery packs to the load, the first contactor is configured to electrically couple the first and second battery packs to the converter, and the first contactor is configured for interrupting the electrical connection between the first and second battery packs and the converter upon receiving the fourth control signal.

According to an embodiment, the first contactor and the paralleled first and second battery packs and in case any further battery packs being electrically arranged in parallel with the first and second battery packs form a first branch of the energy storage system, the energy storage system comprises a second branch having a second contactor and at least one further battery pack, wherein the second contactor is configured for establishing or interrupting an electrical connection of the further battery pack of the second branch to the converter, sending the fourth control signal to the second contactor after checking the earth-fault-free condition of the battery packs of the first branch, wherein the second contactor is configured for interrupting the electrical connection between the further battery pack and the converter upon receiving the fourth control signal; and checking the earth-fault-free condition of the further battery pack of the second branch after the second contactor interrupted the electrical connection of the further battery pack to the converter based on a second voltage signal being representative of a second voltage between second pole of the further battery pack and the ground potential.

The first branch and the second branch may be electrically arranged in series. The earth-fault-free condition of the battery pack of the second branch may be checked in correspondence to the first or second battery packs but based on the second voltage signal instead of the first voltage signal. Optionally, the second branch comprises two or more of the further battery packs. In this case, the further battery packs may be electrically arranged in parallel. The paralleled further battery packs of the second branch are paralleled with respect to each other only. In particular, they are not paralleled with respect to single battery packs of the first branch. The paralleled further battery packs may be checked with respect to the earth-fault-free condition one after the other.

According to an embodiment, the energy storage system comprises the second switch being electrically arranged in series with the battery cells between the first pole and the second pole, and the second switch is configured for interrupting or establishing the serial connection of the battery cells between the first pole and the second pole.

According to an embodiment, the energy storage system, comprises the second battery pack electrically arranged in parallel with the first battery pack, wherein the second battery pack is configured in correspondence to the first battery pack.

According to an embodiment, the energy storage system comprises the converter configured for electrically coupling at least the first battery pack to the load, and the first contactor electrically coupled to the converter and being configured to electrically couple the first battery pack to the converter.

According to an embodiment, the energy storage system, comprises: at least the paralleled first and second battery packs, wherein the converter is configured for electrically coupling the first and second battery packs to the load, wherein the first contactor is configured for electrically coupling the first and second battery packs to the converter, and wherein the first contactor is configured for establishing or interrupting the electrical connection between the first and second battery packs and the converter.

According to an embodiment, the first contactor and the paralleled first and second battery packs and in case any further battery packs being electrically arranged in parallel with the first and second battery packs form the first branch of the energy storage system, and the energy storage system comprises the second branch having the second contactor and at least one further battery pack, wherein the second contactor is configured to establish or interrupt an electrical connection of the further battery pack of the second branch to the converter. A structure and functionality of the second branch may correspond to the structure and, respectively, functionality of the first branch. The second branch may comprise two or more of the further battery packs being electrically arranged in parallel with each other.

According to an embodiment, the method comprises, after determining whether the second condition is fulfilled: sending a fifth control signal to the first contactor, wherein the first contactor is configured for establishing the electrical connection between the first battery pack and in case any further battery pack of the energy storage system and the converter upon receiving the fourth control signal; determining whether the first voltage signal raises above a predetermined third voltage threshold; and determining the first battery pack and, respectively, in case any further battery pack of the energy storage system as not being in the earth-fault-free condition when the first voltage signal raises above the predetermined third voltage threshold. This enables to continuously monitoring the battery packs with respect to the earth-fault-free condition while the battery packs are coupled to the load via the converter and while the battery packs supply energy to the load.

According to an embodiment, the energy storage system comprises a second insulation monitoring device, wherein the second insulation monitoring device is electrically coupled to the second branch and is configured for checking an earth-fault-free condition of the further battery packs of the second branch. A structure and functionality of the second insulation monitoring device may correspond to the structure and functionality of the first insulation monitoring device. For example, the second insulation monitoring device comprises: a third resistor having a predetermined third resistance, wherein a second pole of one of the further battery packs of the second branch is electrically coupled to the ground potential via the third resistor; a second voltmeter being electrically coupled to a first pole of the corresponding further battery pack and the ground potential, and being configured to measure a second voltage between the first pole of the corresponding further battery pack and the ground potential; a fourth resistor having a predetermined fourth resistance and being configured for providing an electric coupling of the first pole of the corresponding further battery pack to the ground potential; and a third switch electrically coupled to the fourth resistor and being configured for establishing or interrupting the electric coupling of the second pole of the corresponding further battery pack to the ground potential depending on a state of the third switch. The second IMD may comprise a housing in which its components are arranged. Optionally, the third resistor may be integrated within the further voltmeter, wherein in this case the further voltmeter may be integrated within one of the further battery packs. So, the first IMD may be assigned to the first branch and the second IMD may be assigned to the second branch for checking the battery packs of the corresponding branch with respect to their earth-fault-free conditions.

According to an embodiment, the converter has a first terminal and a second terminal configured for electrically coupling the converter to the load, the first terminal is coupled to the ground potential via a fifth resistor, the second terminal is coupled to the ground potential via a sixth resistor, and a resistance of the fifth resistor is different from a resistance of the sixth resistor. These features may represent an asymmetric soft grounding of the converter. The asymmetric soft grounding may contribute to that an earth fault arsing during normal operation of the energy storage system causes a detectable shift in the first voltage signal in Phase III, in other words the third phase.

The method may be embodied as a computer program. The computer program may comprise computer-readable instruction which may cause the controller to carry out the method when being executed by the processor of the controller. The computer program may be stored on a computer-readable medium. The computer-readable medium may be a floppy disk, a hard disk, an USB (Universal Serial Bus) storage device, a RAM (Random Access Memory), a ROM (Read Only Memory), an EPROM (Erasable Programmable Read Only Memory) or a FLASH memory. The computer readable medium may also be a data communication network, e.g. the Internet, which allows downloading a program code. In general, the computer-readable medium may be a non-transitory or transitory medium.

These and other aspects of the invention will be apparent from and elucidated with reference to the embodiments described hereinafter.

BRIEF DESCRIPTION OF THE DRAWINGS

The subject matter of the invention will be explained in more detail in the following text with reference to exemplary embodiments which are illustrated in the attached drawings.

Fig. 1 shows a block diagram of an exemplary embodiment of an energy storage system;

Fig. 2 shows a block diagram of an exemplary embodiment of an energy storage system;

Fig. 3 shows a block diagram of an exemplary embodiment of an energy storage system;

Fig. 4 shows a block diagram of an exemplary embodiment of a voltmeter;

Fig. 5 shows a block diagram of an exemplary embodiment an insulation monitoring device;

Fig. 6 shows an example of a first diagram with a first voltage signal in case of the energy storage system being in an earth-fault-free condition;

Fig. 7 shows an example of a second diagram with the first voltage signal in case of the energy storage system not being in the earth-fault-free condition;

Fig. 8 shows an example of a third diagram describing a relationship between an estimated isolation resistance and a ratio of an IMD voltage to a battery pack voltage;

**EP 4 675 875 A1**

Fig. 9 shows a flow diagram of an exemplary embodiment of a method for checking an earth-fault-free condition of the energy storage system.

Fig. 10 shows a flow diagram of an exemplary embodiment of a method for checking an earth-fault-free condition of the energy storage system.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

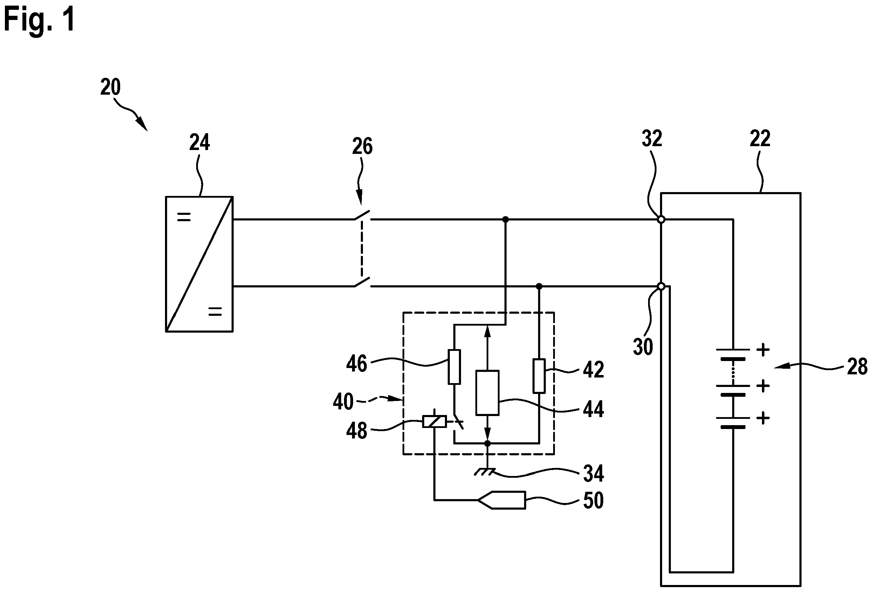

Fig. 1 shows a block diagram of an exemplary embodiment of an energy storage system 20. The energy storage system 20 is configured for providing electric energy to a load (not shown). The load may be an electric motor, e.g., a motor for driving an electric vehicle (not shown). The electric vehicle may be configured for transporting one or more persons and/or goods. The electric vehicle may be a mining truck, a train, a tram, or a subway.

The energy storage system 20 comprises a first battery pack 22, a converter 24, and a first Insulation Monitoring Device (IMD) 40. The first battery pack 22 has a first pole 30, a second pole 32, and at least two battery cells 28 electrically arranged in series between the first pole 20 and the second pole 32. When the energy storage system 20 is arranged in the electric vehicle for providing electric energy to the motor of the electric vehicle, the first battery pack 22 and in case any further battery pack of the energy storage system 20 may be referred to as propulsion battery packs of the electric vehicle.

The converter 24 is an electric converter, such as a rectifier and/or inverter. The first battery pack 22 is electrically couplable to the converter 24 via a contactor 26. The first contactor 26 is configured to electrically couple the first battery pack 22 to the converter 24 or to decouple the first battery pack 22 from the converter 24 depending on state of the contactor 26. In particular, the electric coupling between the first battery pack 22 and the converter 24 is established in a closed state of the contactor 26 and the electric coupling between the first battery pack 22 and the converter 24 is interrupted in an open state of the contactor 26. The contactor 26 may be or may comprise a relay.

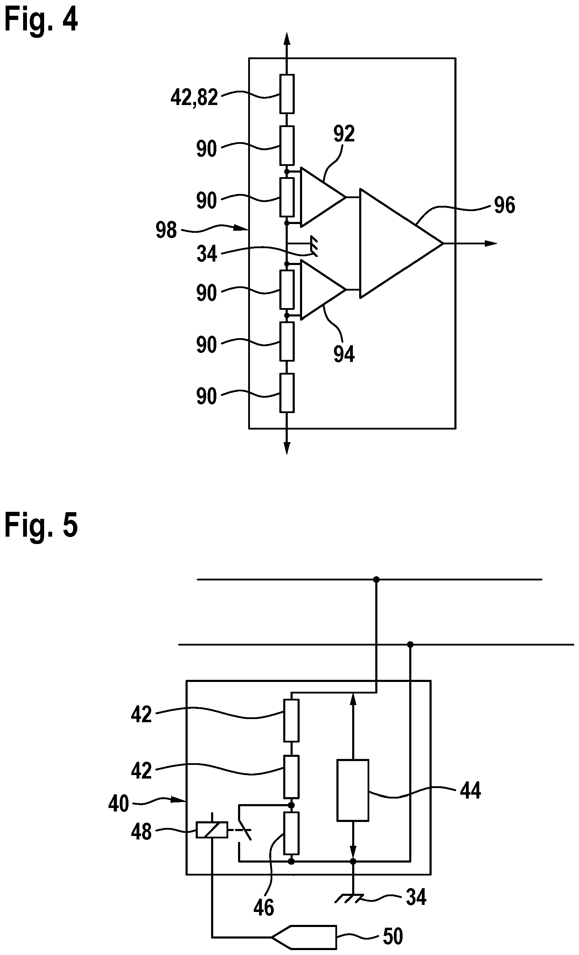

The first IMD 40 is configured for checking an earth-fault-free condition of the energy storage system 20. The first IMD 40 comprises a first resistor 42, a first voltmeter 44, a second resistor 46, a first switch 48, and a controller 50. The first resistor 42 has a predetermined first resistance. The first resistor 42 is electrically coupled to the first pole 30 and to a ground potential 34. As such, the first resistor 42 electrically couples the first pole 30 to the ground potential 34. Optionally, the first resistor 42 may be implemented within a further voltmeter 98 (see figure 4). The first voltmeter 44 is electrically coupled to the second pole 32 and to the ground potential 34. The first voltmeter 44 is configured to measure a first voltage between the second pole 32 and the ground potential 34. The second resistor 46 has a predetermined second resistance. The second resistor 46 is electrically coupled to the second pole 32 and is couplable to the ground potential 34 via the first switch 48. So, the second resistor 46 electrically couples the second pole 32 to the ground potential 34 depending on a state of the first switch 48.

The first switch 48 may comprise a relay. Power contacts of the first switch 48 are electrically coupled to the second resistor 46 and, respectively, to the ground potential 34. A control contact of the first switch 48 is coupled to the controller 50. The first switch 48 is configured for establishing or interrupting the electric coupling of the second pole 32 to the ground potential 34 depending on a state of the first switch 48. In particular, when the first switch 48 is in an open state, the electric coupling of the second pole 32 to the ground potential 34 is interrupted, and when the first switch 48 is in a closed state, the electric coupling of the second pole 32 to the ground potential 34 is established. Optionally, the first IMD 48 may comprise a housing (not shown) in which its components are arranged.

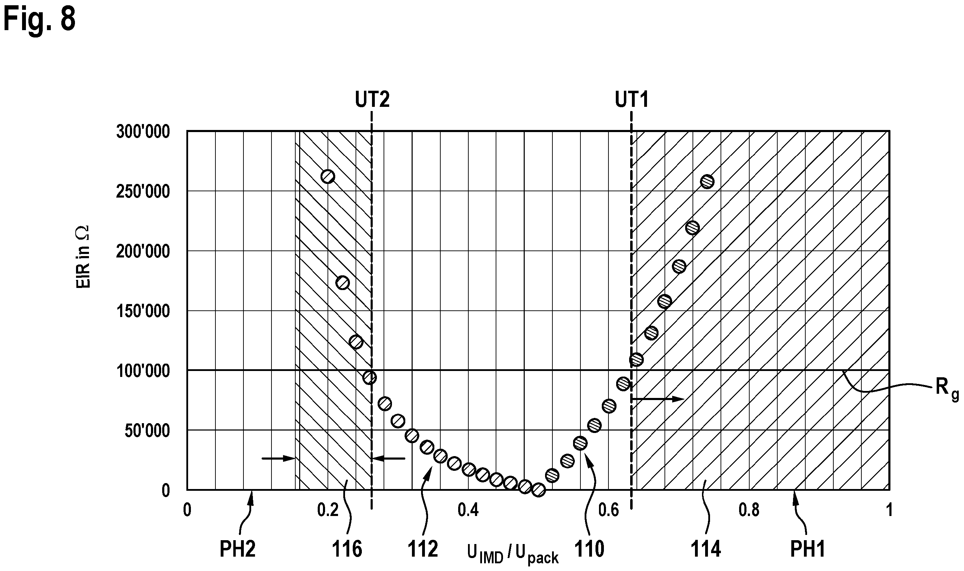

The controller 50 may be a component of the IMD 40. The controller 50 is communicatively coupled to the first voltmeter 44 and to the first switch 48. The controller 50 is configured for checking the earth-fault-free condition of the energy storage system 20. The controller 50 comprises a memory (not shown) for storing one or more voltage values and/or one or more voltage thresholds, and a processor (not shown) being communicatively coupled with the memory and being configured to carry out the method as described below with respect to figure 8.

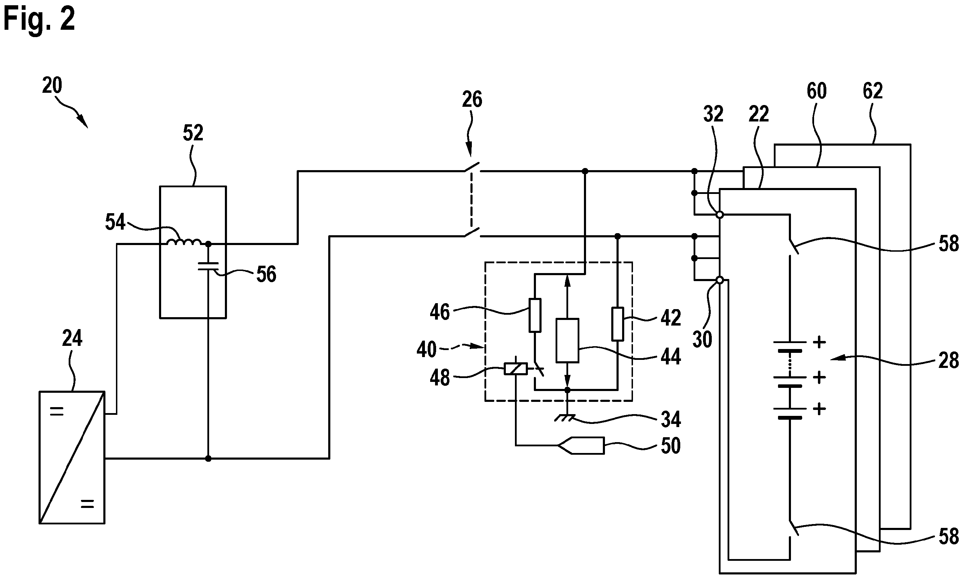

Fig. 2 shows a block diagram of an exemplary embodiment of an energy storage system 20. The energy storage system 20 shown in figure 2 may widely correspond to the energy storage system 20 explained with respect to figure 1. Therefore and in order to process provide a concise description, only those features of the energy storage system 20 shown in figure 2 are described in the following, in which the energy storage system 20 shown in figure 2 differs from the energy storage system 20 explained with respect to figure 1.

The energy storage system 20 comprises a second battery pack 60 electrically arranged in parallel with the first battery pack 22. Optionally, the energy storage system 20 may comprise even more battery packs electrically arranged in parallel with the first and second battery pack 22, 60, e.g., a third battery pack 62. The second and third battery packs 60, 62 and in case any further battery packs may be configured in correspondence to the first battery pack 22. That the second and third battery packs 60, 62 and in case any further battery packs are configured in correspondence to the first battery pack 22 may mean that the second and third battery packs 60, 62 and in case any further battery packs each have the same structure and comparable components as the first battery pack 22. In particular, the second and third battery packs 60, 62 and in case any further battery packs mentioned in this description may comprise its own first pole, second pole, and two or more battery cells being electrically arranged in series between the corresponding first and second poles.

The energy storage system 20, in particular the first battery pack 22 may comprise one or more second switches 58 being electrically arranged in series with the battery cells 28 of the first battery pack 22 between the first pole 30 and the second pole 32 of the first battery pack 22. Each of the second switches 58 of the first battery pack 22 is configured for interrupting or establishing the serial connection of the battery cells 28 of the first battery pack 22 between the first and second poles of the first battery pack 22. The second switch 58 may be arranged anywhere within the serial connection of the battery cells 28 between the first and second poles 30, 32, for example between the first pole 30 and the battery cells 28, or between the battery cells 28 and the second pole 32. Correspondingly, the second and the third and in case any further battery packs 60, 62 each comprises at least one respective second switch 58 for interrupting or establishing the serial connection of the corresponding battery cells 28 between the first and second poles of the corresponding battery pack 60, 62.

The converter 24 is configured for electrically coupling the first, second, and third battery packs 22, 60, 62 to the load. The first contactor 26 is configured for electrically coupling the first, second, and third battery packs 22, 60, 62 to the converter 24. The first contactor 26 is configured for establishing or interrupting the electrical connection between the first, second, and third battery packs 22, 60, 62 and the converter 24.

A first filter 52 may be electrically arranged between the converter 24 and the first contactor 26. The first filter 52 may comprise a first inductor 54 and a first capacitor 56. The first inductor 54 may be electrically arranged in series between the first contactor 26 and the converter 24. The first capacitor 56 may be electrically arranged in parallel to the first inductor 54. The first filter 52 is configured for establishing a voltage conversion together with the converter 24, as it is known in the art.

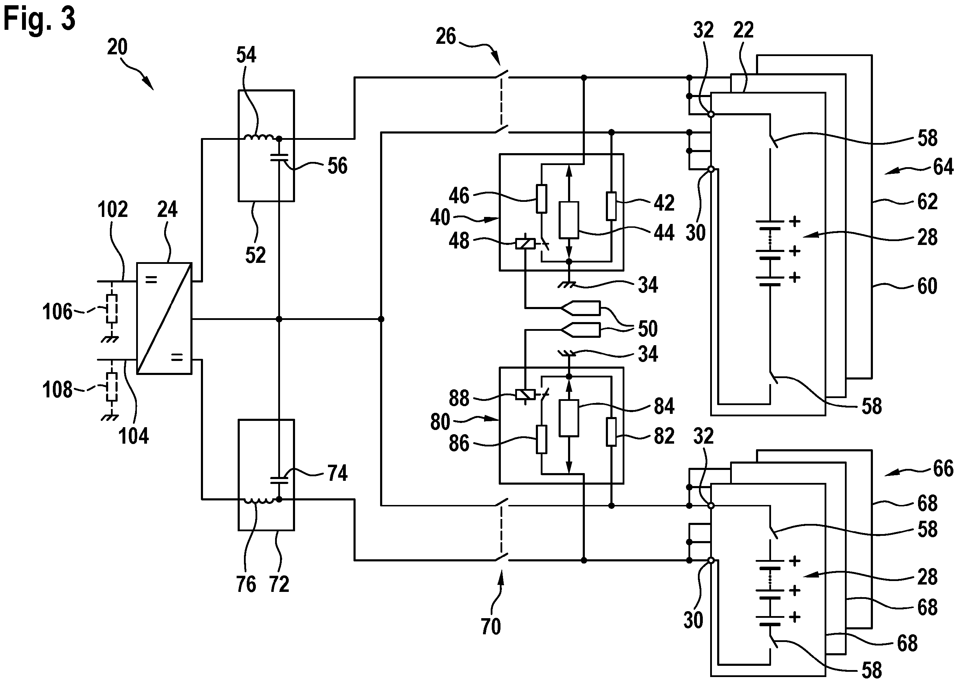

Fig. 3 shows a block diagram of an exemplary embodiment of an energy storage system 20. The energy storage system 20 shown in figure 3 may widely correspond to the energy storage system 20 explained with respect to figure 2. Therefore and in order to process provide a concise description, only those features of the energy storage system 20 shown in figure 3 are described in the following, in which the energy storage system 20 shown in figure 3 differs from the energy storage system 20 explained with respect to figure 2.

The first contactor 26 and the paralleled first, second, and third battery packs 22, 60, 62 and in case any further battery packs being electrically arranged in parallel with the first and second battery packs 22, 60 form a first branch 64 of the energy storage system 20. The energy storage system 20 may comprise a second branch 66 having a second IMD 80, a second contactor 70 and at least one further battery pack 68, preferably two or more further battery packs 68 electrically arranged in parallel with respect to each other. The second contactor 70 is configured to establish or interrupt an electrical connection of the further battery packs 68 of the second branch 66 to the converter 24. A structure and functionality of the second branch 66 may correspond to the structure and, respectively, functionality of the first branch 64.

The second insulation monitoring device 80 is electrically coupled to the second branch 66. The second insulation monitoring device 80 is configured for checking an earth-fault-free condition of the further battery packs 68 of the second branch 66. The second insulation monitoring device 80 may comprise a third resistor 82, a second voltmeter 84, a fourth resistor 86, and a third switch 88. The third resistor 82 may have a predetermined third resistance. The first poles 30 of the further battery packs 68 may be electrically coupled to the ground potential 34 via the third resistor 82. The second voltmeter 84 may be electrically coupled to the first poles 30 of the further battery packs 68 and to the ground potential 34. The second voltmeter 84 may being configured to measure a second voltage between the first poles 30 of the further battery packs 68 and the ground potential 34. The fourth resistor 86 has a predetermined fourth resistance. The fourth resistor 86 is configured for providing an electric coupling of the second poles 32 of the further battery packs 68 to the ground potential 34. Power contacts of the third switch 88 may be electrically coupled to the fourth resistor 86 and to the ground potential 34, whereas a control contact of the third switch 88 may be communicatively coupled to the controller 50. The third switch 88 may be configured for establishing or interrupting the electric coupling of the second poles 32 of the further battery packs 68 to the ground potential 34 depending on a state of the third switch 88. The second IMD 80 may comprise a housing in which its components are arranged. Optionally, the third resistor 82 may be integrated within the further voltmeter 98 (see figure 4).

A second filter 72 may be electrically arranged between the converter 24 and the second contactor 70. The second filter 72 may comprise a second inductor 74 and a second capacitor 76. The second inductor 74 may be electrically arranged in series between the second contactor 70 and the converter 24. The second capacitor 76 may be electrically arranged in parallel to the second inductor 74. The second filter 72 is configured for establishing a voltage conversion together with the converter 24, as it is known in the art.

The converter 24 has a first terminal 102 and a second terminal 104 configured for electrically coupling the converter 24 to the load. The first terminal 102 may be electrically coupled to the ground potential 34 via a fifth resistor 106 and the second terminal 104 may be electrically coupled to the ground potential 34 via a sixth resistor 108, wherein a resistance of the fifth resistor 106 is different from a resistance of the sixth resistor 108. The fifth and sixth resistors 106, 108 represent an asymmetric soft grounding of the converter 24.

Fig. 4 shows a block diagram of an exemplary embodiment of a voltmeter, e.g., of a further voltmeter 98 independent from the first or second voltmeter 44, 84. As already stated above, the first resistor 42 and/or the third resistor 82 may be implemented within a respective further voltmeter 98. The further voltmeter 98 may be arranged within one of the battery packs 22, 60, 62, 68 for measuring the voltage provided by the corresponding battery pack 22, 60, 62, 68. The further voltmeter 98 may comprise two or more further resistors 90 electrically arranged in series with the first or, respectively, third resistor 42, 82. The first or, respectively, third resistor 42, 82 may be electrically coupled to the ground potential 34 via one or more of these further resistors 90. The further voltmeter 98 may further comprise a first amplifier 92, a second amplifier 94, and a third amplifier 96. The amplifiers 92, 94, 96 provide in combination with the resistors 42, 90 a voltage measurement value, which is representative for the differential input voltage on the terminals of the further voltmeter 98.

Fig. 5 shows a block diagram of an exemplary embodiment an insulation monitoring device, e.g., the first IMD 40. The second IMD 80 may be configured correspondingly. The first IMD 40 shown in figure 5 may be used as an alternative to the first IMD 40 described with respect to figures 1, 2, and/or 3. As such, the first IMD 40 is configured for checking the earth-fault-free condition of the energy storage system 20. The first IMD 40 comprises two first resistors 42, the first voltmeter 44, the second resistor 46, the first switch 48, and the controller 50. The first resistors 42 have the predetermined first resistance. The first poles 30 of the battery packs 22, 60, 62 of the first branch 64 may be electrically coupled to the ground potential 34 while the first IMD 40. The first resistors 42 are electrically coupled to the second poles 32 of the battery packs 22, 60, 62 of the first branch 64 and to the first switch 48. The first voltmeter 44 is electrically coupled to the second poles 32 of the battery packs 22, 60, 62 of the first branch 64 and to the ground potential 34. The first voltmeter 44 is configured to measure a first voltage between the second pole 32 and the ground potential 34. The second resistor 46 has the predetermined second resistance. The second resistor 46 is electrically coupled to the second poles 32 of the battery packs 22, 60, 62 of the first branch 64 via the first resistors 42 and to the ground potential 34. The first switch 48 may form an electrical bypass around the second resistor 46. For example, the second resistor 46 may be bypassed by the first switch 48 when the first switch 48 is in its closed state and the second resistor 46 may not be bypassed by the first switch 48 when the first switch 48 is in its open state.

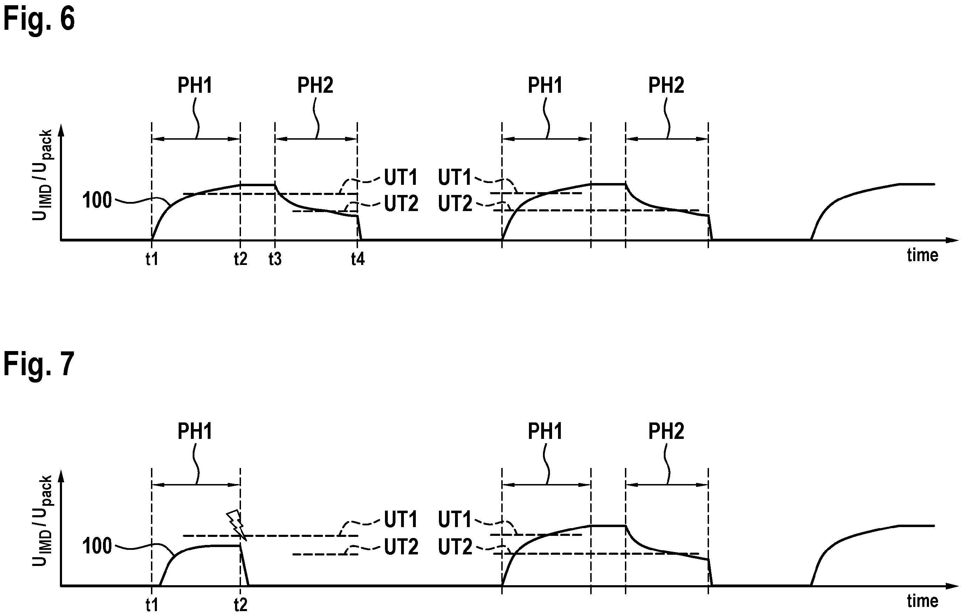

Fig. 6 shows an example of a first diagram with a first voltage signal 100 in case of the energy storage system 20 being in an earth-fault-free condition. An ordinate of the first diagram shows a ratio of an IMD voltage $U_{IMD}$ to a battery pack voltage $U_{pack}$ and an abscissa of the first diagram shows the time. The IMD voltage $U_{IMD}$ corresponds to the first voltage measured by the first voltmeter 44. The battery pack voltage $U_{pack}$ corresponds to the voltage of the serial connected battery cells 28 of the battery pack which is currently checked, i.e., the first battery pack 22 between a first and a fourth point of time t1, t4. The battery pack voltage $U_{pack}$ may be measured or may be received from a Battery Management System (BMS) (not shown) of the energy storage system 20.

The first voltage signal 100 may be generated by the first voltmeter 44 and may be representative for the first voltage. So, the first voltmeter 44 may generate the first voltage signal 100 depending on the measurement of the first voltage such that the first voltage signal 100 is representative of the first voltage. The battery packs 22, 60, 62 of the first branch 64 may be checked with respect to their earth-fault-free condition based on the first voltage signal 100. The first voltage may be measured and the first voltage signal 100 may be generated continuously when checking the battery packs 22, 60, 62 of the first branch 64 with respect to the earth-fault-free condition.

A first phase ("Phase I") PH1 may range from the first point in time t1 to a second point in time t2. A second phase ("Phase II") PH2 may range from a third point in time t3 to the fourth point in time t4. The first battery pack 22 may be checked during the first phase PH1 starting at the first point in time t1 and during the second phase PH2 starting at the third point in time t3. Afterwards, the first and second phases PH1, PH2 may be repeated to check the second battery pack 60. Then, the first and second phases PH1, PH2 may be repeated for every remaining battery pack 62 of the energy storage system 20.

In case of the energy storage system 20, in particular the first the battery pack 22, being in an earth-fault-free condition, the first voltage signal 100 raises above a predetermined first voltage threshold TH1 within the first phase PH1 and drops below the predetermined second voltage threshold TH2 in the second phase PH2. This principle may repeat for every earth-fault-free battery pack 60, 62 of the first branch 64. An exemplary calculation of the first and second voltage thresholds is explained in more detail below with respect to figure 8.

Fig. 7 shows an example of a second diagram showing the first voltage signal 100 in case of the energy storage system 20 not being in the earth-fault-free condition. The second diagram itself, in particular the ordinate and the abscissa, corresponds to the first diagram, wherein the first voltage signal 100 in the second diagram differs from the first voltage signal 100 in the second diagram. In particular, in the second diagram, the first voltage signal 100 does not raise above the first voltage threshold UT1 in the first phase PH1 ranging from the first to the second points of time t1, t2. Thus, the first battery pack 22 has an earth-fault and thereby a faulty insulation. So, the first battery pack 22 is not in an earth-fault-free condition.

During the next first phase PH1, the first voltage signal 100 raises above the first voltage threshold UT1, and drops below the second voltage threshold UT2 within the following second phase PH2. Thus, the second battery pack is 60 is in an earth-fault-free condition.

The first and second diagram contain the first voltage signal 100 as an example. The detection principles of the first and second diagrams explained in the foregoing may be easily transferred to a second voltage signal (not shown) which may be generated by the second voltmeter 84 and which is representative for the second voltage. So, an earth-fault-free condition of the further battery packs 68 of the second branch 66 may be determined based on the second voltage signal in the same way as the earth-fault-free condition of the battery packs 22, 60, 62 of the first branch 64 are determined based on the first voltage signal 100.

Fig. 8 shows an example of a third diagram describing a relationship between an Estimated Isolation Resistance (EIR) and a ratio of the IMD voltage $U_{IMD}$ to the battery pack voltage $U_{pack}$. In figure 8, $R_g$ = 100 k$\Omega$ is set as an exemplary insulation resistance of an earth-fault-free battery pack, e.g., of the first battery pack 22. The exemplary insulation resistance $R_g$ may be measured between a midpoint of the serial connected battery cells 28 of the corresponding battery pack 22, 60, 62, 68.

First measurements 110 are carried out during the first phase PH1. The first measurements 110 may be above the exemplary insulation resistance $R_g$ in a first allowable region 114 and below the exemplary insulation resistance $R_g$ outside of the first allowable region 114 before. Second measurements 112 are carried out during the second phase PH2. The second measurements 112 may be above the exemplary insulation resistance $R_g$ in a second allowable region 116 and then below the exemplary insulation resistance $R_g$ outside of the second allowable region 116.

The instantaneous insulation resistance $R_g$ may be determined by the following formulas in relationship to the IMD voltage $U_{IMD}$, and to the battery pack voltage $U_{pack}$:

$$R_g = \frac{U_{imd} - U_{pack}/2}{U_{pack} - U_{imd}} \cdot R_1, \text{ for the first phase PH1,}$$

and

$$R_g = \frac{U_{imd} - U_{pack}/2}{\frac{U_{pack} - U_{imd}}{R_1} - \frac{U_{imd}}{R_2}}, \text{ for the second phase PH2.}$$

with $R_1$ representing the first resistance of the first resistor 42 and/or the third resistance of the third resistor 82, and $R_2$ representing the second resistance of the second resistor 46 and/or the fourth resistance of the fourth resistor 86.

The first and second voltage thresholds UT1, UT2 may be predetermined in advance e.g., depending on the first and, respectively, second resistances $R_1$, $R_2$, with a graphic or implicit method as shown in Fig. 8 and may be stored on the memory of the controller 50, for example.

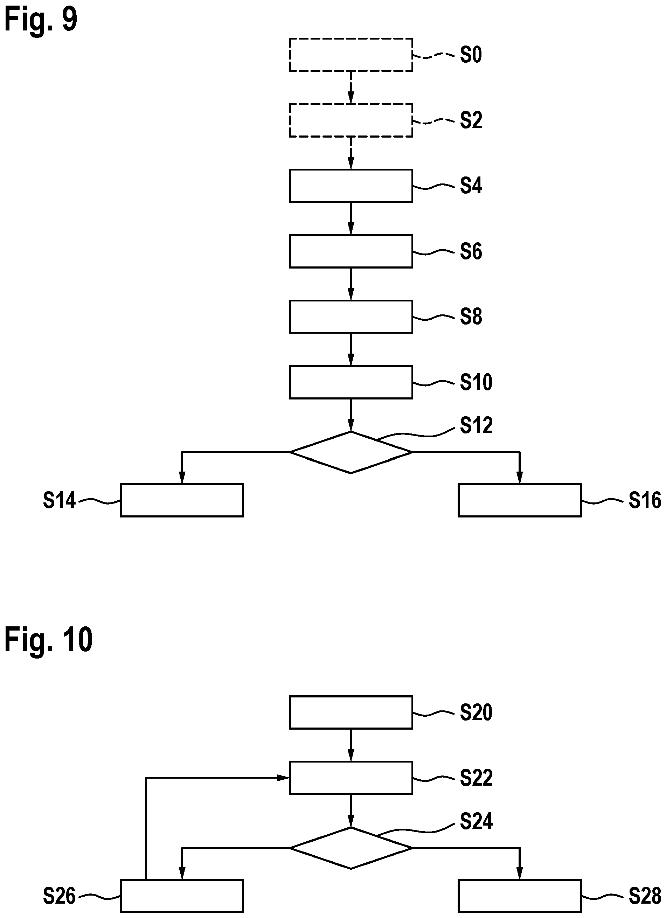

Fig. 9 shows a flow diagram of an exemplary embodiment of a method for checking an earth-fault-free condition of the energy storage system 20, in particular of one or more of the battery packs 22, 60, 62, 68 of the energy storage system 20, e.g., of the first battery pack 22.

In an optional step S0, which may be carried out when the first, second, and third battery packs 20, 60, 62 are coupled to the converter 24, a fourth control signal may be sent to the first contactor 26, wherein the first contactor 26 is configured for interrupting the electrical connection between the first, second, and third battery packs 22 and the converter 24 upon receiving the fourth control signal.

In an optional step S2, which may be carried out when the energy storage system 20 comprises the second switch(es) 58, a second control signal may be sent to the second switch 58 of the battery pack which is currently checked with respect to its earth-fault-free condition, i.e., the first battery pack 22. The second switch 58 may be configured to establish the serial connection of the battery cells 28 between the two poles 30, 32 of the first battery pack 22 upon receiving the second control signal. In addition, a third control signal may be sent to the second switches 58 of the other battery packs 60, 62 of the first branch 64, wherein the second switches 58 are configured to interrupt a serial connection of the battery cells 28 of the corresponding battery pack 60, 62 while the earth-fault-free condition of the first battery pack 22 is checked,

In a step S4, the first voltage signal 100 being representative of the first voltage between the second pole 32 and the ground potential 34 may be received, e.g., by the controller 50.

In a step S6, a first condition may be determined as being fulfilled, e.g., by the controller 50, when the first voltage signal 100 raises above the first voltage threshold UT1 within the first phase PH1 and the first condition may be determined as not being fulfilled when the first voltage signal 100 does not raise above the first voltage threshold UT1 within the first phase PH1. In case of the optional step S2 has been carried out, it may be determined whether the first condition is fulfilled or not a predetermined duration after the second switch 58 established the serial connection of the battery cells 28 between the two poles 30, 32 of the first battery pack 22. The predetermined duration may be in the range of 0.01 s to 1.000 s, e.g., of 0.5 s to 60 s, e.g., of 1 s to 30 s.

In a step S8, a first control signal may be sent to the first switch 48, e.g., by the controller 50, wherein the first switch 48 is configured to connect the second pole 32 of the first battery pack 22 to the ground potential 34 via the second resistor 46 having the predetermined second resistance $R_2$ upon receiving the first control signal.

In a step S 10, a second condition may be determined as being fulfilled when the first voltage signal 100 falls below the predetermined second voltage threshold UT2 after the first switch 48 connected the second pole 32 of the first battery pack 22 to the ground potential 34 in the second phase PH2, and the second condition may be determined as not being fulfilled when the first voltage signal 100 does not fall below the predetermined second voltage threshold UT2 after the first switch 48 connected the second pole 32 of the first battery pack 22 to the ground potential 34 in the second phase PH2.

In a step S12, the first battery pack 22 may be determined as being in the earth-fault-free condition when the first condition and the second condition are fulfilled, or the first battery pack 22 may be determined as not being in the earth-fault-free condition when the first condition and/or the second condition are not fulfilled. In case of the first battery pack 22 being in the earth-fault-free condition, the method may proceed in a step S14. In case of the first battery pack 22 not being in the earth-fault-free condition, the method may proceed in a step S16.

In step S14, the energy storage system 20, in particular the first battery pack 22, may be operated normally. For example, in case of the energy storage system 20 providing the propulsion energy to the electric vehicle, the energy storage system 20 and in particular the first battery pack 22 may be used for providing the propulsion energy for the electric vehicle. Alternatively or additionally, another battery pack 60, 62 of the first branch 64 or one of the further battery packs 68 of the second branch 66 may be checked with respect to their earth-fault-free conditions, e.g., by repeatedly carrying out the steps S2 to S 12.

In step S 16, at least one safety measure may be initiated. The safety measure may comprise or may be one or more safety measures out of a group of safety measures, the group comprising: deactivating the energy storage system 20, deactivating the first battery pack 22, and sending a warning signal to an operator of the energy storage system, e.g., of the vehicle. Alternatively or additionally, another battery pack 60, 62 of the first branch 64 or one of the further battery packs 68 of the second branch 66 may be checked with respect to their earth-fault-free conditions, e.g., by repeatedly carrying out the steps S2 to S 12.

When carrying out the method again, e.g., in order to check the second battery pack 60 with respect to its earth-fault-free condition, the third control signal may be sent to the second switch 58 of the first battery pack 22, wherein the second switch 58 of the first battery pack 22 is configured to interrupt the serial connection of the battery cells 28 of the first battery pack 22 upon receiving the third control signal. Then, the second control signal may be sent to the second switch 58 of the second battery pack 60, in correspondence to step S2 described above, wherein the second switch 58 of the second battery pack 60 is configured to establish the serial connection of the battery cells 28 of the second battery pack 60 upon receiving the second control signal. Then, the earth-fault-free condition of the second battery pack 60 may be checked, e.g., in correspondence with steps S4 to S 16 described above.

So, when the first branch 64 comprises more than two battery packs 20, 60, as e.g. described with respect to figure 2, these battery packs 62 may be checked one after the other after checking the first and second battery packs 20, 60. So, all battery packs 20, 60, 62 of the first branch 64 may be checked with respect to the earth-fault-free condition one after the other. The serial connections of the battery cells 28 between the two poles 30, 32 of all the battery packs 20, 60, 62 which are not currently checked may be interrupted by the corresponding second switches 58 upon receiving the corresponding third control signals. The earth-fault-free condition of the second or in case any further battery packs 60, 62 may be checked in the same way as the earth-fault-free condition of the first battery pack 22 is checked, in particular via monitoring the first voltage signal 100 before and after closing the corresponding first switch 48.

When the energy storage system 20 comprises the second branch 66 having the second contactor 70 and at least one of the further battery packs 68, with the second contactor 70 being configured for establishing or interrupting the electrical connection of the further battery packs 68 of the second branch 66 to the converter 24, as e.g. described with respect to figure 3, a fourth control signal may be sent to the second contactor 70 after checking the earth-fault-free condition of the battery packs 22, 60, 62 of the first branch 64. The second contactor 70 may be configured for interrupting the electrical connection between the further battery packs 68 and the converter 24 upon receiving the fourth control signal. Then, after the second contactor 70 interrupted the electrical connection of the further battery pack to the converter, the earth-fault-free condition of the further battery packs 68 of the second branch 66 may be checked one after the other in correspondence to the above explained checking of the earth-fault-free condition of the battery packs 22, 60, 62 of the first branch 64 based on a second voltage signal (not shown) being representative of the second voltage between first poles 30 of the further battery packs 68 and the ground potential 34. The analysis of the second voltage signal may correspond to the analysis of the first voltage signal 100. In particular, it may be checked whether second voltage signal raises above the first voltage threshold UT1 in the first phase PH1 and falls below the second voltage threshold UT2 in the second phase PH2.

The first branch 64 and the second branch may 66 be electrically arranged in series. The earth-fault-free condition of the battery packs 68 of the second branch 66 may be checked in correspondence to the first or second battery packs 22, 62, but based on the second voltage signal instead of the first voltage signal. Optionally, the second branch 66 comprises two or more of the further battery packs 68. In this case, the further battery packs 68 may be electrically arranged in parallel. The paralleled further battery packs 68 of the second branch 66 are paralleled with respect to each other only. In particular, they are not paralleled with respect to single battery packs 22, 60, 62 of the first branch 64. The paralleled further battery packs 68 may be checked with respect to the earth-fault-free condition one after the other.

Fig. 10 shows a flow diagram of an exemplary embodiment of a method for checking an earth-fault-free condition of the energy storage system 20. The method explained with respect to figure 10 may be carried out after the method explained with respect to figure 9 has been carried out with the result that all battery packs 22, 60, 62, 68 of the energy storage system 20 are in the earth-fault-free condition. The method explained with respect to figure 10 implements a third phase of checking the earth-fault-free condition of the energy storage system 20, in particular during a normal operation of the energy storage system 20.

In a step S20, a fifth control signal may be sent to the first contactor 26, and in case to the second contactor 70, wherein the contactors 26, 70 are configured to establishing the electrical connection between the battery packs 22, 60, 62, 68 of the energy storage system 20 and the converter 24 upon receiving the fourth control signal. When the electrical connection between the battery packs 22, 60, 62, 68 of the energy storage system 20 and the converter 24 is established, the energy storage system 20 may be in its normal operation. The method explained with respect to figure 10 may be carried out continuously and/or repeatedly as long as the energy storage system 20 is operated normally.

In a step S22, the first voltage signal 100 and in case the second voltage signal may be received.

In a step S24, it may be checked whether the first and/or second voltage signals 100 raise above a predetermined third voltage threshold. The third voltage threshold may be determined empirically, by simulation and/or by calculation. The first battery pack 22 and, respectively, in case any further battery pack 60, 62, 68 of the energy storage system 20 may be determined as not being in the earth-fault-free condition when the first and/or, respectively, second voltage signal 100 raises above the predetermined third voltage threshold. Then, the method proceeds in a step S28. Otherwise, the method proceeds in step S26.

In step S26, the energy storage system 20, in particular the battery packs 22, 60, 62, 68 may be operated normally. In addition, the method of figure 10 may proceed in S22 by monitoring the first and/or second voltage signals 100 continuously. This monitoring phase during normal operation of the energy storage system 20 may be referred to as third phase. Alternatively, the method may be terminated.

In step S28, the at least one safety measure may be initiated.

The method explained with respect to figure 9 and the method explained with respect to figure 10 may be implemented within the same algorithm and as such may form one single method only. The method(s) may be embodied as computer program(s). The computer program(s) may comprise computer-readable instructions which may cause the controller 50 to carry out the method when being executed by the processor of the controller 50. The computer program may be stored on a computer-readable medium. The computer-readable medium may be a floppy disk, a hard disk, an USB (Universal Serial Bus) storage device, a RAM (Random Access Memory), a ROM (Read Only Memory), an EPROM (Erasable Programmable Read Only Memory) or a FLASH memory. The computer readable medium may also be a data communication network, e.g. the Internet, which allows downloading a program code. In general, the computer-readable medium may be a non-transitory or transitory medium.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

## LIST OF REFERENCE SYMBOLS

| | |
|---|---|
| Energy storage system | 20 |
| First battery pack | 22 |
| Converter | 24 |
| First contactor | 26 |
| Battery cells | 28 |
| First pole | 30 |
| Second pole | 32 |
| Ground potential | 34 |

(continued)

| | | |
|---|---|---|
| First IMD | 40 | |
| First resistor | 42 | |
| First Voltmeter | 44 | |
| Second resistor | 46 | |
| First switch | 48 | |
| Controller | 50 | |
| First filter | 52 | |
| First inductor | 54 | |
| First capacitor | 56 | |
| Second switch | 58 | |
| Second battery pack | 60 | |
| Third battery pack | 62 | |
| First branch | 64 | |
| Second branch | 66 | |
| Further battery pack | 68 | |
| Second contactor | 70 | |
| Second filter | 72 | |
| Second inductor | 74 | |
| Second capacitor | 76 | |
| Second IMD | 80 | |
| Third resistor | 82 | |
| Second Voltmeter | 84 | |
| Fourth resistor | 86 | |
| Third switch | 88 | |
| Further resistor | 90 | |
| First amplifier | 92 | |
| Second amplifier | 94 | |
| Third amplifier | 96 | |
| Further voltmeter | 98 | |
| First voltage signal | 100 | |
| First terminal | 102 | |
| Second terminal | 104 | |
| Fifth resistor | 106 | |
| sixth resistor | 108 | |
| First measurements | 110 | |
| Second measurements | 112 | |
| First allowable region | 114 | |
| Second allowable region | 116 | |
| First voltage threshold | UT1 | |
| Second voltage threshold | UT2 | |
| Phase I | PH1 | |
| Phase II | PH2 | |
| Zeitpunkte | t1, t2, t3, t4 | |
| Estimated insulation resistance | EIR | |
| IMD voltage | $U_{IMD}$ | |
| Battery pack voltage | $U_{pack}$ | |
| Exemplary insulation resistance | $R_g$ | |

## Claims

1. A method for checking an earth-fault-free condition of an energy storage system (20), wherein the energy storage system (20) comprises a first battery pack (22) having a first pole (30), a second pole (32), and at least two battery cells (28) electrically arranged in series between the first pole (30) and the second pole (32), the method comprising:

receiving a first voltage signal (100) being representative of a first voltage between the second pole (32) and the ground potential (34);

determining a first condition as being fulfilled when the first voltage signal (100) raises above a first voltage threshold (UT1) and determining the first condition as not being fulfilled when the first voltage signal (100) does not raise above the first voltage threshold (UT1);

sending a first control signal to a first switch (48), wherein the first switch (48) is configured to connect the second pole (32) to the ground potential (34) via a second resistor (46) having a predetermined second resistance upon receiving the first control signal;

determining a second condition as being fulfilled when the first voltage signal (100) falls below a predetermined second voltage threshold (UT2) after the first switch (48) connected the second pole (32) to the ground potential (34) and determining the second condition as not being fulfilled when the first voltage signal (100) does not fall below the predetermined second voltage threshold (UT2) after the first switch (48) connected the second pole (32) to the ground potential (34);

determining the first battery pack (22) as being in the earth-fault-free condition when the first condition and the second condition are fulfilled;

determining the first battery pack (22) as not being in the earth-fault-free condition when the first condition and/or the second condition are not fulfilled; and

initiating at least one safety measure when the first battery pack (22) is not in the earth-fault-free condition.

2. The method according to claim 1, wherein the energy storage system (20) comprises a second switch (58) being electrically arranged in series with the battery cells (28) between the first pole (30) and the second pole (32) and wherein the second switch (58) is configured for interrupting or establishing the serial connection of the battery cells (28) between the first pole (30) and the second pole (32), the method comprising before receiving the first voltage signal (100):

sending a second control signal to the second switch (58) of the first battery pack (22), wherein the second switch (58) is configured to establish the serial connection of the battery cells (28) between the two poles (30, 32) of the first battery pack (22) upon receiving the second control signal, wherein it is determined whether the first condition is fulfilled a predetermined duration after the second switch (58) established the serial connection of the battery cells (28) between the two poles (30, 32) of the first battery pack (22).

3. The method according to one of the preceding claims, wherein the energy storage system (20) comprises a second battery pack (60) electrically arranged in parallel with the first battery pack (22), wherein the second battery pack (60) is configured in correspondence to the first battery pack (22), and wherein a second switch (58) of the second battery pack (60) interrupts a serial connection of battery cells (28) of the second battery pack (60) between two poles (30, 32) of the second battery pack (60) while the earth-fault-free condition of the first battery pack (22) is checked, the method comprising:

sending a third control signal to the second switch (58) of the first battery pack (22) after checking the earth-fault-free condition of the first battery pack (22), wherein the second switch (58) of the first battery pack (22) is configured to interrupt the serial connection of the battery cells (28) between the two poles (30, 32) of the first battery pack (22) upon receiving the third control signal;

sending the second control signal to the second switch (58) of the second battery pack (60), wherein the second switch (58) of the second battery pack (60) is configured to establish the serial connection of the battery cells (28) between the two poles (30, 32) of the second battery pack (60) upon receiving the second control signal; and

checking the earth-fault-free condition of the second battery pack (60).

4. The method in accordance with one of the preceding claims, wherein the energy storage system (20) comprises a converter (24) configured for electrically coupling at least the first battery pack (22) to a load and a first contactor (26) configured for electrically coupling the first battery pack (22) to the converter (24), the method comprising, before receiving the first voltage signal (100):

sending a fourth control signal to the first contactor (26), wherein the first contactor (26) is configured for interrupting the electrical connection between the first battery pack (22) and the converter (24) upon receiving the fourth control signal; and

determining whether the first condition is fulfilled after the first contactor (26) interrupted the electrical connection of the first battery pack (22) to the first converter (24), and in case after the second switch (58) established the serial connection of the battery cells (28) between the two poles (30, 32) of the first battery pack (22).

**5.** The method in accordance with claim 4, wherein

the energy storage system (20) comprises at least the paralleled first and second battery packs (22, 60),
the converter (24) is configured to electrically couple the first and second battery packs (22, 60) to the load,
the first contactor (26) is configured to electrically couple the first and second battery packs (22, 60) to the converter (24), and
the first contactor (26) is configured for interrupting the electrical connection between the first and second battery packs (22, 60) and the converter (24) upon receiving the fourth control signal.

**6.** The method in accordance with claim 5, wherein

the first contactor (26) and the paralleled first and second battery packs (22, 60) and in case any further battery packs (62) being electrically arranged in parallel with the first and second battery packs (22, 60) form a first branch (64) of the energy storage system (20),
the energy storage system (20) comprises a second branch (66) having a second contactor (70) and at least one further battery pack (68), wherein the second contactor (70) is configured for establishing or interrupting an electrical connection of the further battery pack (68) of the second branch (66) to the converter (24),
sending the fourth control signal to the second contactor (70) after checking the earth-fault-free condition of the battery packs (22, 60, 62) of the first branch (64), wherein the second contactor (70) is configured for interrupting the electrical connection between the further battery pack (68) and the converter (24) upon receiving the fourth control signal; and
checking the earth-fault-free condition of the further battery pack (68) of the second branch (66) after the second contactor (70) interrupted the electrical connection of the further battery pack (68) to the converter (24) based on a second voltage signal being representative of a second voltage between first pole (30.) of the further battery pack (68) and the ground potential (34).

**7.** The method in accordance with one of claims 4 to 6, after determining whether the second condition is fulfilled comprising:

sending a fifth control signal to the first contactor (26), wherein the first contactor (26) is configured for establishing the electrical connection between the first battery pack (22) and in case any further battery pack of the energy storage system (20) and the converter (24) upon receiving the fourth control signal;
determining whether the first voltage signal raises above a predetermined third voltage threshold; and
determining the first battery pack (22) and, respectively, in case any further battery pack of the energy storage system (20) as not being in the earth-fault-free condition when the first voltage signal raises above the predetermined third voltage threshold.

**8.** Controller (50) for checking an earth-fault-free condition of an energy storage system (20), wherein the energy storage system (20) comprises a first battery pack (22) having a first pole (30), a second pole (32), and at least two battery cells (28) electrically arranged in series between the first pole (30) and the second pole (32), the controller (50) comprising:

a memory for storing one or more voltage values and/or one or more voltage thresholds (UT1, UT2); and
a processor being communicatively coupled with the memory and being configured to carry out the method in accordance with one of the proceeding claims.

**9.** Insulation monitoring device (40) for checking an earth-fault-free condition of an energy storage system (20), wherein the energy storage system (20) comprises a first battery pack (22) having a first pole (30), a second pole (32), and at least two battery cells (28) electrically arranged in series between the first pole (30) and the second pole (32), the insulation monitoring device (40) comprising:

a first resistor (42) having a predetermined first resistance;
a first voltmeter (44) for being electrically coupled to the second pole (32) and the ground potential (34), and being configured to measure a first voltage between the second pole (32) and the ground potential (34);
a second resistor (46) having a predetermined second resistance and being configured for providing an electric coupling of the second pole (32) to the ground potential (34);

a first switch (48) electrically coupled to the second resistor (46) and being configured for establishing or interrupting the electric coupling of the second pole (32) to the ground potential (34) depending on a state of the first switch (48); and

a controller in accordance with claim 8 and being communicatively coupled to the first voltmeter (44) and the first switch (48).

10. Energy storage system (20) for providing electric energy to a load, the energy storage system (20) comprising a first battery pack (22) having a first pole (30), a second pole (32), and at least two battery cells (28) electrically arranged in series between the first pole (30) and the second pole (32), and a first insulation monitoring device (40) in accordance with claim 9, wherein

the first voltmeter (44) of the insulation monitoring device (40) is electrically coupled to the second pole (32) and the ground potential (34), and is configured to measure the first voltage between the second pole (32) and the ground potential (34), and

the first switch (48) electrically coupled to the second resistor (46) and is configured for establishing or interrupting the electric coupling of the second pole (32) to the ground potential (34) depending on the state of the first switch (48).

11. Energy storage system (20) in accordance with claim 10, comprising:
a second switch (58) being electrically arranged in series with the battery cells (28) between the first pole (30) and the second pole (32) and the second switch (58) is configured for interrupting or establishing the serial connection of the battery cells (28) between the first pole (30) and the second pole (32).

12. Energy storage system (20) in accordance with one of claims 10 or 11, comprising:
a second battery pack (60) electrically arranged in parallel with the first battery pack (22), wherein the second battery pack (60) is configured in correspondence to the first battery pack (22).

13. Energy storage system (20) in accordance with one of claims 10 to 12, comprising:

a converter (24) configured for electrically coupling at least the first battery pack (22) to a load; and
a first contactor (26) electrically coupled to the converter (24) and being configured to electrically couple the first battery pack (22) to the converter (24).

14. Energy storage system (20) in accordance with claim 13, comprising:
at least the paralleled first and second battery packs (22, 60), wherein the converter (24) is configured for electrically coupling the first and second battery packs (22, 60) to the load, wherein the first contactor (26) is configured for electrically coupling the first and second battery packs (22, 60) to the converter (24), and wherein the first contactor (26) is configured for establishing or interrupting the electrical connection between the first and second battery packs (22, 60) and the converter (24).

15. Energy storage system (20) in accordance with claim 14, wherein

the first contactor (26) and the paralleled first and second battery packs (22, 60) and in case any further battery packs (68) being electrically arranged in parallel with the first and second battery packs (22, 60) form a first branch (64) of the energy storage system (20), and

the energy storage system (20) comprises a second branch (66) having a second contactor (70) and at least one further battery pack (68), wherein the second contactor (70) is configured to establish or interrupt an electrical connection of the further battery pack (68) of the second branch (66) to the converter (24).

16. Energy storage system (20) in accordance with claim 15, comprising:
a second insulation monitoring device (80) in accordance with claim 9, wherein the second insulation monitoring device (80) is electrically coupled to the second branch (66) and is configured for checking an earth-fault-free condition of the further battery packs (68) of the second branch (66).

17. Energy storage system (20) in accordance with one of claims 13 to 16, wherein

the converter has a first terminal and a second terminal configured for electrically coupling the converter to the load,

the first terminal is coupled to the ground potential via a fifth resistor,
the second terminal is coupled to the ground potential via a sixth resistor, and
a resistance of the fifth resistor is different from a resistance of the sixth resistor.

EP 4 675 875 A1

**Fig. 1**

18

# Fig. 2

EP 4 675 875 A1

# Fig. 3

EP 4 675 875 A1

# Fig. 4

# Fig. 5

**Fig. 6**

**Fig. 7**

Fig. 8

Fig. 9

```
        ┌ ─ ─ ─ ─ ─ ┐
        │           │ ─ ─ ~ S0
        └ ─ ─ ─ ─ ─ ┘
              │
              ▼
        ┌ ─ ─ ─ ─ ─ ┐
        │           │ ─ ─ ~ S2
        └ ─ ─ ─ ─ ─ ┘
              │
              ▼
        ┌───────────┐
        │           │ ── S4
        └───────────┘
              │
              ▼
        ┌───────────┐
        │           │ ── S6
        └───────────┘
              │
              ▼
        ┌───────────┐
        │           │ ── S8
        └───────────┘
              │
              ▼
        ┌───────────┐
        │           │ ── S10
        └───────────┘
              │
              ▼
                        ~ S12
            ◇
    ┌───────┘       └───────┐
    ▼                       ▼
┌───────┐               ┌───────┐
S14 ~   │               │   ~ S16
└───────┘               └───────┘
```

Fig. 10

```
        ┌───────────┐
        │           │ ── S20
        └───────────┘
              │
              ▼
    ┌──────►┌───────────┐
    │       │           │ ── S22
    │       └───────────┘
    │             │
    │             ▼
    │                     ~ S24
    │         ◇
    │  ┌──────┘   └───────┐
    │  ▼                  ▼
┌───────┐             ┌───────┐
S26 ~   │             │   ~ S28
└───────┘             └───────┘
```

Europäisches
Patentamt

European
Patent Office

Office européen
des brevets

# EUROPEAN SEARCH REPORT

**Application Number**

EP 24 18 6623

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/245853 A1 (WEISS HAROLD [US] ET AL) 25 August 2016 (2016-08-25) | 1-3, 8-10, 13-17 | INV.<br>H02H3/16<br>H02H7/18 |
| A | * paragraphs [0006], [0033] - [0037]; figures 1,2,3,4a,4b * | 4-7,11, 12 | G01R31/52 |
|  | ----- | | |
| X | JP 2014 098681 A (OMRON AUTOMOTIVE ELECTRONICS) 29 May 2014 (2014-05-29)<br>* paragraphs [0033] - [0040]; figures 12-14 * | 1 | |
|  | ----- | | |
| A | JP 6 014404 B2 (KEIHIN CORP)<br>25 October 2016 (2016-10-25)<br>* paragraphs [0014] - [0032]; figures 1-4 * | 1 | |
|  | ----- | | |
| A | KR 2016 0133542 A (CONTINENTAL AUTOMOTIVE GMBH [DE]) 22 November 2016 (2016-11-22)<br>* paragraphs [0014] - [0032]; figures 1-4 * | 1,9 | |
|  | ----- | | **TECHNICAL FIELDS SEARCHED (IPC)**<br><br>H02J<br>G01R<br>H02H |

The present search report has been drawn up for all claims

| Place of search | Date of completion of the search | Examiner |
|---|---|---|
| Munich | 27 December 2024 | Colombo, Alessandro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

....................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 6623

This annex lists the patent family members relating to the patent documents cited in the above-mentioned European search report.
The members are as contained in the European Patent Office EDP file on
The European Patent Office is in no way liable for these particulars which are merely given for the purpose of information.

27-12-2024

| Patent document cited in search report | Publication date | Patent family member(s) | Publication date |
|---|---|---|---|
| US 2016245853 A1 | 25-08-2016 | CN 107533096 A | 02-01-2018 |
| | | EP 3259607 A1 | 27-12-2017 |
| | | JP 6800870 B2 | 16-12-2020 |
| | | JP 2018507409 A | 15-03-2018 |
| | | KR 20170121217 A | 01-11-2017 |
| | | KR 20230017920 A | 06-02-2023 |
| | | US 2016245853 A1 | 25-08-2016 |
| | | WO 2016134205 A1 | 25-08-2016 |
| JP 2014098681 A | 29-05-2014 | JP 5615342 B2 | 29-10-2014 |
| | | JP 2014098681 A | 29-05-2014 |
| JP 6014404 B2 | 25-10-2016 | CN 103576043 A | 12-02-2014 |
| | | JP 6014404 B2 | 25-10-2016 |
| | | JP 2014029293 A | 13-02-2014 |
| | | US 2014035594 A1 | 06-02-2014 |
| KR 20160133542 A | 22-11-2016 | CN 106068458 A | 02-11-2016 |
| | | DE 102014204870 A1 | 17-09-2015 |
| | | EP 3120161 A1 | 25-01-2017 |
| | | KR 20160133542 A | 22-11-2016 |
| | | US 2017108544 A1 | 20-04-2017 |
| | | WO 2015140107 A1 | 24-09-2015 |

EPO FORM P0459